# EUROPEAN PATENT APPLICATION

(11) **EP 1 843 388 A1**
(43) Date of publication of application: **10.10.2007**
(21) Application number: 05819956.3
(22) Date of filing: 22.12.2005
(51) Int. Cl.: H01L 21/205, C23C 16/44, H01L 21/304

(54) **SUBSTRATE SURFACE TREATING APPARATUS**

(30) Priority: 24.12.2004 JP 2004373099
(71) Applicant: KABUSHIKI KAISHA WATANABE SHOKO, Chuo-ku, Tokyo 103-0022 (JP)
(72) Inventor: Umeda, Masaru c/o Kabushiki Kaisha Watanabe Shoko, Tokyo 1030022 (JP)
(74) Representative: Weitzel, Wolfgang
(86) International application number: PCT/JP2005/023645
(87) International publication number: WO 2006/068241

(57) **Abstract**

There is provided a substrate surface treating apparatus by which the temperature of a carrier gas can be increased high and thus treatment can be more uniformly performed. An upstream ring is connected to a heating medium inlet for applying a prescribed heating medium, and a downstream ring is connected to a heating medium outlet for ejecting the heating medium. A plurality of heat transmitting paths are connected to the upstream ring and the downstream ring by having flow directions of the adjacent heating medium reaching the downstream ring from the upstream ring are opposite, and a gas is used as the heating medium.

## Description

### TECHNICAL FIELD

The present invention relates to a substrate surface treating apparatus, and more particularly to a substrate surface treating apparatus that supplies a carrier gas to a substrate surface of, e.g., a silicon substrate, a compound semiconductor substrate, or a glass substrate by spraying to perform a surface treatment.

### BACKGROUND ART

Patent Document 1: Japanese Patent Application Laid-open Publication No. H11(1999)-80958

A substrate surface treating apparatus is generally used as a treating apparatus that performs a treatment, e.g., cleaning/oxidation of a semiconductor substrate surface or deposition of a thin film in an industrial field concerning a semiconductor. Further, in an industrial field concerning glass, the substrate surface treating apparatus is used for manufacturing, e.g., a liquid crystal display or a plasma display.

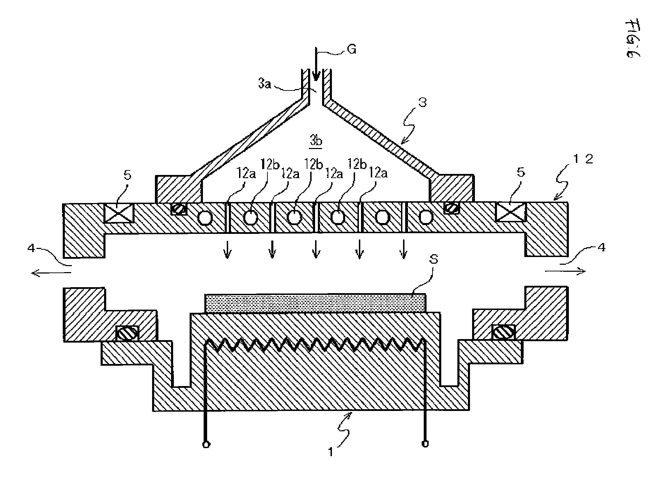

FIG. 5 is a vertical cross-sectional view showing a structural example of an MOCVD chamber portion in a silicon substrate surface treating apparatus according to Conventional Example 1.

In FIG. 5, a silicon substrate S is heated by a heater unit 1 provided at a lower part of the substrate.

A supply die 3 in which a carrier gas supply opening 3a from which a carrier gas G is supplied for the purpose of uniformly supplying a raw material for a thin film to the silicon substrate S and a substantially conical carrier gas diffusing portion 3b that is expanded toward the lower side in the drawing with this carrier gas supply opening 3a at the center are formed is provided on a gas nozzle plate 2 disposed to face the silicon substrate S. Further, a plurality of carrier gas vent holes 2a which communicate with the carrier gas diffusing portion 3b to spray the carrier gas G toward a surface of the silicon substrate S are formed in the gas nozzle plate 2, and a path of the carrier gas G extending from the carrier gas supply opening 3a to each carrier gas vent hole 2a through the gas diffusing portion 3b is determined as a carrier gas spraying duct.

The carrier gas G supplied through the carrier gas spraying duct provokes a thermal decomposition reaction on the silicon substrate S, thereby depositing a thin film on the surface of the silicon substrate S. The carrier gas G that has fulfilled a role of forming the thin film is discharged by, e.g., a non-illustrated vacuum pump through a carrier gas exhaust opening 4 formed between the heater unit 1 and the gas nozzle plate 2.

On the other hand, the gas nozzle plate 2 receives radiation heat from the heater unit 1 and the silicon substrate 2 and its temperature is thereby increased. In general, since a temperature at a central part of the gas nozzle plate 2 is higher than that at a peripheral part, an overheated state is apt to occur. For this reason, aluminum that is superior in thermal conductivity is generally used for the gas nozzle plate 2. Furthermore, an ingenuity, e.g., providing a coolant circulation path 5 around the gas nozzle plate 2 as a peripheral water-cooling scheme is exercised for the purpose of preventing the gas nozzle plate 2 from being overheated.

However, in such a structure like Conventional Example 1, a diameter of the gas nozzle plate 2 must be increased in order to cope with the silicon substrate S having a large hole diameter. Therefore, it is known that a temperature difference of 50 to 80°C occurs between the central part and the peripheral part of the gas nozzle plate 2 which is of the peripheral water-cooling type. This temperature difference is a serious phenomenon for the substrate surface treating apparatus that performs a uniform treatment.

For example, a steam pressure of a solid raw material used in MOCVD is generally considerably low, and hence the solid raw material must be heated to a high temperature in order to stably obtain a necessary amount of a CVD raw material. The carrier gas G that is flowed to carry the raw material gas is also supplied to the carrier gas supply opening 3a while being heated to approximately 200°C. Furthermore, a heater 6 is provided around the conical carrier gas diffusing portion 3b for the purpose of heating the carrier gas G.

Moreover, when a temperature of the carrier gas G containing the raw material gas is lowered, a component of the raw material gas is condensed on an inner surface constituting the gas nozzle plate 2 or in each carrier gas vent hole 2a. On the other hand, it is known that a thin film or an intermediate product is deposited on an inner surface constituting a gas nozzle chamber or in each carrier gas vent hole 2a when a temperature of the carrier gas G containing the raw material gas is excessively increased more than necessary. As a result, obtaining a desired thin film on the silicon substrate S becomes difficult.

FIG. 6 is a vertical cross-sectional view showing a structural example of an MOCVD chamber portion of a silicon treating apparatus according to Conventional Example 2.

FIG. 6 shows a structure where a plurality of carrier gas vent holes 12a are formed in a gas nozzle plate 12 and heat transmitting paths 12b for a heating medium are provided between the plurality of carrier gas vent holes 12a. In this example, the respective heat transmitting paths 12b are parallel to each other, and a temperature difference on a surface of the gas nozzle plate 12 is reduced to approximately 30°C when flow directions of the heating medium are equalized.

### DISCLOSURE OF INVENTION

### PROBLEM TO BE SOLVED BY THE INVENTION

However, an area of a surface to be treated tends to be further increased, and a demand for a homogenization accuracy of a treatment has been increased. Therefore, there is a problem that, e.g., handling in Conventional Example 2 is insufficient as a substrate surface treating apparatus that is demanded in recent years. Moreover, since the carrier gas to be used has a high temperature of 200°C, just providing the heat transmitting paths 12b between the plurality of carrier gas vent holes 12a cannot easily maintain this high-temperature state.

It is an object of the present invention to provide a substrate surface treating apparatus that can perform a uniform treatment at a higher temperature.

### MEANS FOR SOLVING PROBLEM

To achieve this object, according to the present invention, there is provided a substrate surface treating apparatus which supplies a gas to a substrate surface from a plurality of gas vent holes to perform a surface treatment of the substrate, comprising:
an upstream ring connected with a heating medium inlet from which a predetermined heating medium is supplied; a downstream ring connected with a heating medium outlet from which the heating medium is discharged; and a plurality of heat transmitting paths connected with the upstream ring and the downstream ring in such a manner that flow directions of the heating medium which reach the downstream ring from the upstream ring and are adjacent to each other become opposite,
wherein the heating medium is a gas.

The substrate surface treating apparatus according to the present invention is characterized in that a heating medium circulation path reaching the downstream ring from the upstream ring through the plurality of heat transmitting paths is provided to a thermal conversion plate constituting an end edge portion of a gas spraying duct reaching the gas vent holes from a supply source of the gas, and the thermal conversion plate is heated to a substantially uniform temperature by the heating medium circulation path.

The substrate surface treating apparatus according to the present invention is characterized in that the plurality of gas vent holes are vertically formed in the thermal conversion plate, and the gas is heated to a substantially uniform temperature when passing through the plurality of gas vent holes on the upstream side where the heat transmitting paths are placed on an internal diameter side having substantially the same planar shape as the upstream ring.

The substrate surface treating apparatus according to the present invention is characterized in that a flow rate adjustment mechanism that limits a flow rate of the heating medium flowing through the heat transmitting paths is provided to at least one of a connecting portion between the heat transmitting paths and the downstream ring and a connecting portion between the heat transmitting paths and the upstream ring.

The substrate surface treating apparatus according to the present invention is characterized in that the gas is a single gas of one of argon, nitrogen and air, or a mixed gas of two or more of them.

The substrate surface treating apparatus according to the present invention is characterized in that the gas has a higher temperature than a supply temperature of the gas.

### EFFECT OF THE INVENTION

In the substrate surface treating apparatus according to the present invention, the upstream ring is connected with the heating medium inlet from which a predetermined heating medium is supplied, the downstream ring is connected with the heating medium outlet from which the heating medium is discharged, the plurality of heat transmitting paths are connected with the upstream ring and the downstream ring in such a manner that contiguous flow directions of the heating medium reaching the downstream ring from the upstream ring become opposite to each other, and the gas having a higher temperature than a supply temperature of the carrier gas is used, thereby realizing a highly homogeneous treatment.

In the substrate surface treating apparatus according to the present invention, the heating medium circulation path reaching the downstream ring from the upstream ring through the plurality of heat transmitting paths is provided on the thermal conversion plate constituting the end edge portion of the carrier gas spraying duct reaching the carrier gas vent holes from the supply source of the carrier gas, the thermal conversion plate can be heated to a substantially uniform temperature by this heating medium circulation path, and a stable high temperature of the carrier gas can be thereby realized, thus realizing a further highly homogeneous treatment.

In the substrate surface treating apparatus according to the present invention, the plurality of carrier gas vent holes are vertically formed in the thermal conversion plate, and the carrier gas is heated to a substantially uniform temperature on the upstream side of the heat transmitting paths placed on the internal diameter side having the substantially same planar shape as the upstream ring when passing through the plurality of carrier gas vent holes, thereby individually increasing a temperature of the carrier gas passing through the plurality of carrier gas vent holes.

In the substrate surface treating apparatus according to the present invention, the flow rate control mechanism that limits a flow rate of the heating medium flowing through the heat transmitting paths is provided to at least one of a connecting portion between the heat transmitting paths and the downstream ring or that between the heat transmitting paths and the upstream ring, thereby uniformly controlling a temperature of the heating medium flowing through the heat transmitting paths.

### BRIEF DESCRIPTION OF DRAWINGS

FIGS. 1 show a carrier gas heating tube unit used in a substrate surface treating apparatus according to the present invention, in which (A) is a perspective view of an appearance of the carrier gas heating tube unit and (B) is an explanatory view of a duct of a heating medium;
FIG. 2 is a cross-sectional view for explaining a structure depicted in FIG. 1;
FIG. 3 is a cross-sectional view for explaining a structure of a thermal conversion plate;
FIG. 4 is a cross-sectional view of an entire structure of the substrate surface treating apparatus according to the present invention;
FIG. 5 is a cross-sectional view of a substrate surface treating apparatus according to Conventional Example 1; and
FIG. 6 is a cross-sectional view of a substrate surface treating apparatus according to Conventional Example 2.

### EXPLANATIONS OF LETTERS OR NUMERALS

31 ... supply tube (heating medium inlet)
32 ... upstream ring
33 ... exhaust tube (heating medium outlet)
34 ... downstream ring
35 ... connection tube
   35a ... heat transmitting tube portion (heat transmitting path)
   35b ... orifice
22 ... gas nozzle plate (thermal conversion plate)
   22c ... carrier gas vent hole

### BEST MODES FOR CARRYING OUT THE INVENTION

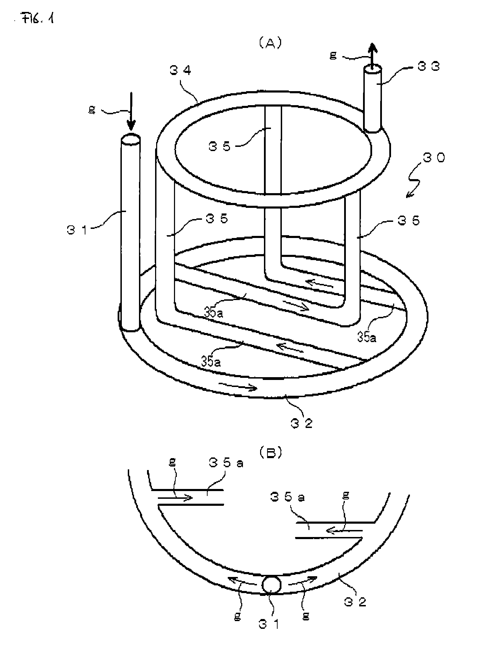

An embodiment of a substrate surface treating apparatus according to the present invention will now be explained in detail with reference to the accompanying drawings. FIGS. 1 to 4 show an embodiment of a silicon substrate surface treating apparatus according to the present invention.

### <Examination of Problems>

In case of, e.g., a discoid shape, an energy supplied from a heat source is generally reduced as distanced from a heat transmitting path running through a central line of the discoid shape and from the center toward the outer periphery. Based on this fact, in this mode having a plurality of heat transmitting paths, a flow rate of a heating medium in each heat transmitting path must be adjusted in accordance with each heat transmitting path. It is to be noted that adjustment of a flow rate can be obtained based on an experiment.

Further, in FIG. 6 showing Conventional Example 6, when a plurality of heat transmitting paths 12b for a heating medium were assured in a gas nozzle plate 12, carrier gas vent holes 12a were provided between the heat transmitting paths 12b adjacent to each other, the respective heat transmitting paths 12b were set in parallel with each other and directions of the heating medium flowing through the heat transmitting paths 12b adjacent to each other were opposite, a temperature difference in the gas nozzle plate 12 was reduced to -5°C.

Although this result is substantially sufficient as the substrate surface treating apparatus, since flows of the heating medium become complicated, manufacture of the practical gas nozzle plate 12 and a connection method for heating medium circulation are very complicated, and hence this structure cannot be adopted in the substrate surface treating apparatus as it is.

When flows of the heating medium opposite to each other are configured with respect to a chamber wall (a cylindrical shape, a box-like shape) having a heat source therein, a temperature of the wall can be controlled. In this case, disposing a throttle valve rather than a fixed orifice to each heat transmitting path is convenient.

### <Structure of This Embodiment>

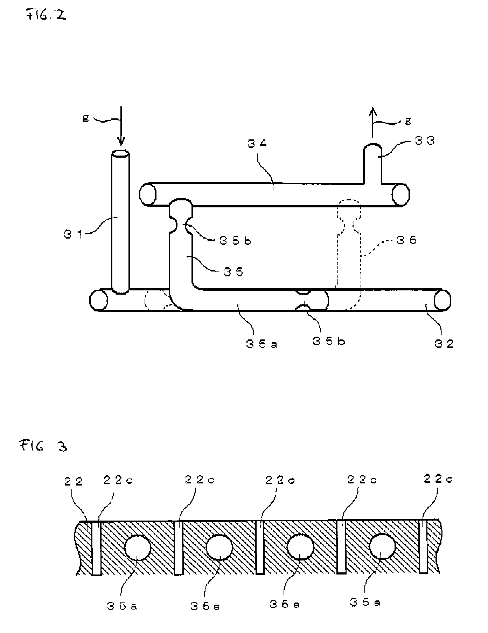

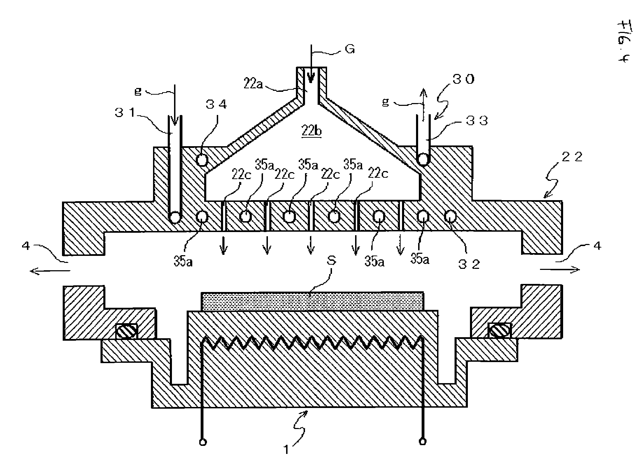

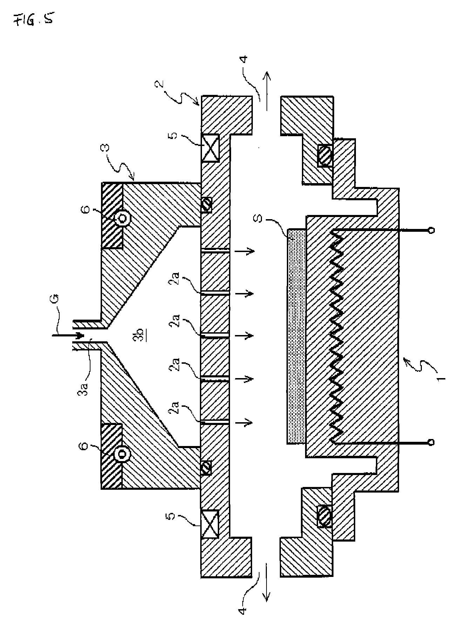

FIG. 1(A) is a perspective view conceptually showing a structure of heating medium circulation adapted to the substrate surface treating apparatus according to the present invention; FIG. 1(B) is an explanatory view of a duct for the heating medium; FIG. 2 is a cross-sectional view conceptually showing the structure of the heating medium circulation adapted to the substrate surface treating apparatus according to the present invention; FIG. 3 is an enlarged cross-sectional view of a primary part of the heating medium circulation adapted to the substrate surface treating apparatus according to the present invention; and FIG. 4 is also a cross-sectional view of the substrate surface treating apparatus according to the present invention.

The heating medium circulation applied to this embodiment includes the above-explained heater unit 1 and a carrier gas exhaust opening 4.

A carrier gas supply opening 22a from which a carrier gas G is supplied for the purpose of uniformly supplying a raw material for a thin film to a silicon substrate S, a substantially conical carrier gas diffusing portion 22b that is expanded toward the lower side in the drawing with this carrier gas supply opening 22a at the center, and a plurality of carrier gas vent holes 22c which communicates with the carrier gas diffusing portion 22b to spray the carrier gas G toward a surface of the silicon substrate S are formed in the gas nozzle plate 22 provided to face the silicon substrate S, and a path of the carrier gas G reaching each carrier gas vent hole 22c from the carrier gas supply opening 22a through the gas diffusing portion 22b is determined as a carrier gas spraying duct.

The carrier gas G supplied through the carrier gas spraying duct provokes a thermal decomposition reaction on the silicon substrate S, thereby depositing a thin film on the surface of the silicon substrate S. The carrier gas G which has fulfilled a role of forming the thin film is discharged by, e.g., a non-illustrated vacuum pump through the carrier gas exhaust opening 4 formed between the heater unit 1 and the gas nozzle plate 2.

On the other hand, a carrier gas heating tube unit 30 that forms heat transmitting paths for a heating medium constituted of a high-temperature gas is arranged in the gas nozzle plate 22.

As shown in FIG. 1, an annular upstream ring 32 which is connected with a supply tube 31 serving as a heating medium inlet and has a larger hole diameter on the lower side and an annular upstream ring 34 which is connected with an exhaust tube 33 serving as a heating medium outlet and has a smaller diameter on the upper side are arranged in parallel with each other in this carrier gas heating tube unit 30, and the carrier gas heating tube unit 30 includes a substantially-L-shaped bent connection tube 35 constituting a plurality of heat transmitting paths which connect the upstream ring 32 with the downstream ring 34 to restrict a flow of the heating medium that is supplied from the heating medium inlet and discharged from the heating medium outlet.

The connection tube 35 includes on the upstream side heat transmitting tube portions 35a which are placed on an internal diameter side having the same planar shape as the upstream ring 32 and have ends connected with the upstream ring 32. In this example, as shown in FIG. 1(B), when the heat transmitting tube portions 35a are alternately connected with the upstream ring 32 with the supply tube 31 being used as a reference, the heating medium which is supplied from the supply tube 31 and dispersed in a lateral direction in the drawing flows through the heat transmitting tube portions 35a adjacent to each other in opposite directions. Furthermore, as shown in FIG. 4. the respective heat transmitting tube portions 35a which are placed on the upstream side of a flow direction of the heating medium to maintain a relatively high temperature state are alternately arranged between the carrier gas vent holes 22c to adjust a temperature of the carrier gas G passing through the carrier gas vent holes 22c.

At this time, when the carrier gas G must be heated, for example, when the present invention is used as a treating apparatus for a substrate surface like a silicon substrate S explained in this embodiment in an industrial field concerning a semiconductor, a high-temperature gas is used as the heating medium. Moreover, when the carrier gas G must be cooled, for example, when the present invention is used as a treating apparatus that cleans a substrate surface of, e.g., a liquid crystal display or a plasma display in an industrial field concerning glass, a coolant or a low-temperature gas is used as the heating medium. As types of the high-temperature gases, argon, nitrogen, air, and others are used, but a gas which is of a type according to a heating temperature (a cooling temperature) of the carrier gas G or a gas subjected to temperature setting is of course used. Additionally, when heating is intended in particular, a temperature of a gas such as a high-temperature gas can be set higher than that of a liquid, and there is an advantage that aged deterioration, i.e., scraping away a duct inner wall of the carrier gas heating tube unit 30 is not observed.

It is to be noted that an orifice that limits a flow rate of the heating medium flowing through the heat transmitting tube portions 35a or a throttle mechanism 35b that adjusts a flow rate can be provided at a connecting portion between each connection tube 35 and the downstream ring 34 (or the upstream ring 32) considering conditions, e.g., a connection distance from the supply tube 31 (a connection position) or a length of each heat transmitting tube portion 35a, thereby uniforming a temperature of the carrier gas G.

As explained above, the heating medium circulation path adapted to the this embodiment includes the upstream ring 32, the downstream ring 34, and the connection tubes 35 forming the plurality of heat transmitting paths connecting the upstream ring 32 with the downstream ring 34, and the gas plate 22 having the plurality of carrier gas vent holes 22c formed therein is constituted as the thermal conversion plate for the carrier gas G.

Further, since the heat transmitting paths formed of the heat transmitting tube portions 35 are parallel to each other and flow directions of the heating medium flowing through the heat transmitting paths adjacent to each other are opposite, a temperature difference produced between an upstream point and a downstream point in the gas nozzle plate 22 having a large hole diameter can be alleviated in particular. This relationship will now be explained hereinafter in detail.

In the heat transmitting paths, when a temperature of the heating medium is higher than that of the gas nozzle plate 22 having a function as the thermal conversion plate, the temperature of the heating medium is transmitted to the gas nozzle plate 22 through the heat transmitting paths. Contrary, when the temperature of the heating medium is lower than that of the gas nozzle plate 22, the gas nozzle plate 22 is cooled. A structure concerning a heat transmitting effect in the thermal conversion plate heated by radiation heat from the heating medium flowing through the heat transmitting paths, the heater, and the silicon substrate S is basically different from that in a conventional substrate surface treating apparatus.

In this thermal conversion, in case of heating the thermal conversion plate, when a temperature of the heating medium in the heat transmitting path on the upstream side is compared with that on the downstream side, the temperature on the upstream side is high, and that on the downstream side is low. Therefore, a temperature difference is produced between the upstream side and the downstream side in the same heat transmitting path. In this thermal conversion, in case of cooling the thermal conversion plate, when a temperature of the heating medium in the heat transmitting path on the upstream side is compared with that on the downstream side, the temperature on the upstream side is low, and that on the downstream side is high. Therefore, a temperature difference is produced between the upstream side and the downstream side in the same heat transmitting path.

Meanwhile, when seeing the entire gas nozzle plate 22, the upstream direction and the downstream direction of the heat transmitting paths adjacent to each other are opposite. Therefore, temperature differences in regions adjacent to each other in the gas nozzle plate 22 are configured as high/low/high/low ....

Here, this structure tries eliminating a factor of a temperature difference that is potentially produced in the gas nozzle plate 22. Therefore, the gas nozzle plate 22 can be further uniformly heated by the heating medium. Realization of uniformity of heating the gas nozzle plate 22 can be also adjusted by adjusting a flow rate of the heating medium in each heat transmitting path using the orifice 8.

In the substrate surface treating apparatus according to this embodiment depicted in FIG. 4, the silicon substrate S is heated by the heater unit 1 provided at the lower portion. The plurality of carrier gas vent holes 22c and the conical carrier gas diffusing portion 22b are disposed in the gas nozzle plate 22 provided to face this silicon substrate S in order to uniformly supply a raw material for a thin film to the silicon substrate S. The carrier gas G supplied through the carrier gas vent holes 22c provokes a thermal decomposition reaction on the silicon substrate S, thereby depositing a thin film on the surface of the silicon substrate S. The carrier gas G that has fulfilled a role of forming the thin film is discharged by, e.g., a vacuum pump through the exhaust opening 4.

The heating medium (a high-temperature gas) is supplied from the supply tube 31 to the gas nozzle plate 22, and discharged from the exhaust tube 33 through the gas nozzle plate 22 for heating medium circulation applied to this embodiment constituted of the upstream ring 32, the connection tubes 35, the downstream ring 34, and others. As a result, on one hand, the heating medium supplies its own thermal energy and fulfills a role as the heating medium. On the other hand, the gas nozzle plate 22 receives supply of heat on its own plate surface from the heating medium to be heated to a uniform temperature.

The carrier gas G that is used to treat the surface of the silicon substrate S is uniformly distributed and supplied from the carrier gas supply opening 3a, heated in the carrier gas vent holes 22c in the gas nozzle plate 22, heats the surface of the silicon substrate S for a surface treatment, and is then discharged from the exhaust opening 4.

### INDUSTRIAL APPLICABILITY

In the substrate surface treating apparatus according to the present invention, the upstream ring is connected with the heating medium inlet from which the predetermined heating medium is supplied, the downstream ring is connected with the heating medium outlet from which the heating medium is discharged, the plurality of heat transmitting paths are connected with the upstream ring and the downstream ring in such a manner that flow directions of the heating medium which reach the downstream ring from the upstream ring and are adjacent to each other become opposite, and a gas having a higher temperature than a supply temperature of the carrier gas is used as the heating medium, thereby realizing a high temperature of the carrier gas and a further homogeneous treatment.

In the substrate surface treating apparatus according to the present invention, the heating medium circulation path which reaches the downstream ring from the upstream ring through the plurality of heat transmitting paths is provided to the thermal conversion plate constituting the end edge portion of the carrier gas spraying path reaching the carrier gas vent holes from the supply source of the carrier gas, and heating the thermal conversion plate to a substantially uniform temperature by the heating medium circulation path enables realizing a stable high temperature of the carrier gas, thereby realizing a further homogeneous treatment.

In the substrate surface treating apparatus according to the present invention, the plurality of carrier gas vent holes are vertically formed in the thermal conversion plate, and the carrier gas is heated to a substantially uniform temperature on the upstream side of the heat transmitting path placed on the internal diameter side having substantially the same planar shape as the upstream ring when passing through the plurality of carrier gas vent holes, thereby individually increasing a temperature of the carrier gas passing through the plurality of carrier gas vent holes.

In the substrate surface treating apparatus according to the present invention, the flow rate adjustment mechanism that limits a flow rate of the heating medium flowing through the heat transmitting paths is provided to at least one of a connecting portion between the heat transmitting paths and the downstream ring and that between the heat transmitting paths and the upstream ring, thus uniformly controlling a temperature of the heating medium flowing through the heat transmitting paths.

## Claims

1. A substrate surface treating apparatus which supplies a gas to a substrate surface from a plurality of gas vent holes to perform a surface treatment of the substrate, comprising:
an upstream ring connected with a heating medium inlet from which a predetermined heating medium is supplied; a downstream ring connected with a heating medium outlet from which the heating medium is discharged; and a plurality of heat transmitting paths connected with the upstream ring and the downstream ring in such a manner that flow directions of the heating medium which reach the downstream ring from the upstream ring and are adjacent to each other become opposite,
wherein the heating medium is a gas.

2. The substrate surface treating apparatus according to claim 1, wherein a heating medium circulation path reaching the downstream ring from the upstream ring through the plurality of heat transmitting paths is provided to a thermal conversion plate constituting an end edge portion of a gas spraying duct reaching the gas vent holes from a supply source of the gas, and the thermal conversion plate is heated to a substantially uniform temperature by the heating medium circulation path.

3. The substrate surface treating apparatus according to claim 2, wherein the plurality of gas vent holes are vertically formed in the thermal conversion plate, and the gas is heated to a substantially uniform temperature when passing through the plurality of gas vent holes on the upstream side where the heat transmitting paths are placed on an internal diameter side having substantially the same planar shape as the upstream ring.

4. The substrate surface treating apparatus according to one of claims 1 to 3, wherein a flow rate adjustment mechanism that limits a flow rate of the heating medium flowing through the heat transmitting paths is provided to at least one of a connecting portion between the heat transmitting paths and the downstream ring and a connecting portion between the heat transmitting paths and the upstream ring.

5. The substrate surface treating apparatus according to one of claims 1 to 4, wherein the gas is a single gas of one of argon, nitrogen and air, or a mixed gas of two or more of them.

6. The substrate surface treating apparatus according to one of claims 1 to 5, wherein the gas has a higher temperature than a supply temperature of the gas.
